# EUROPEAN PATENT APPLICATION

(11) **EP 4 365 237 A1**
(43) Date of publication of application: **08.05.2024**
(21) Application number: 22833280.5
(22) Date of filing: 30.06.2022
(51) Int. Cl.: C08L 79/08, C08L 77/00, C09D 179/08, H05K 3/28

(54) **RESIN COMPOSITION AND METHOD FOR PRODUCING SEMICONDUCTOR DEVICE**

(30) Priority: 30.06.2021 WO PCT/JP2021/024883
(71) Applicant: Resonac Corporation, Tokyo 105-7325 (JP)
(72) Inventor: SATO Mizuki, Tokyo 100-6606 (JP); HASHIMOTO Gaku, Tokyo 100-6606 (JP); SATO Eiichi, Tokyo 100-6606 (JP)
(74) Representative: Hoffmann Eitle
(86) International application number: PCT/JP2022/026233
(87) International publication number: WO 2023/277134

(57) **Abstract**

Provided is a resin composition containing: at least one resin selected from the group consisting of a polyamide, a polyamideimide, a polyimide, and a polyamic acid; at least one solvent A having a lactone structure; and at least one glycol ester solvent B 1 that is compatible with the solvent A, in which a mass ratio of the solvent A/the solvent B 1 is in a range from 90/10 to 75/25, and the resin includes a resin (A) having a structural unit represented by formula (Ia) below and a structural unit represented by formula (IIa) below, or a resin (B) having a structural unit represented by formula (IIa) below and a structural unit represented by formula (IVa) below.

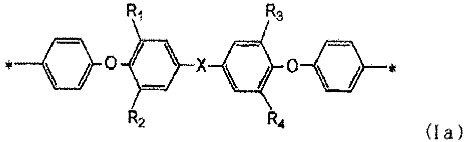

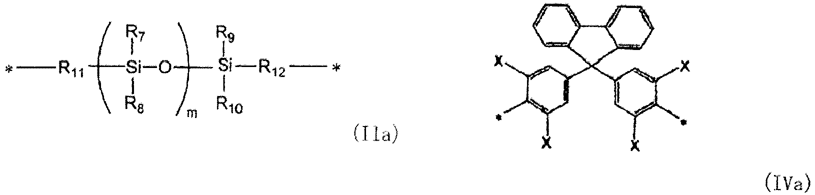

## Description

### TECHNICAL FIELD

One embodiment of the present invention relates to a resin composition containing a resin such as a polyamideimide, and an organic solvent, and more particularly to a resin composition which substantially does not contain NMP. Another embodiment of the present invention relates to a method of manufacturing a semiconductor device using the resin composition of the above embodiment.

### BACKGROUND ART

Resins such as polyamideimides, polyamides, and polyimides are excellent in various properties such as heat resistance, chemical resistance, and mechanical properties. Therefore, the resins are widely used, for example, for various usage applications as binder resins for paints. Polar solvents are used during the synthesis of resins such as polyamideimides, polyamides, and polyimides, and during the preparation of varnishes or paints. From thereamong, N-methyl-2-pyrrolidone (NMP) is commonly used as a suitable organic solvent for polyamideimide resins (Patent Document 1).

However, in recent years, regulations on the use of organic solvents have become stricter from the viewpoints of environmental protection and safety and health. In addition, there are concerns about NMP being harmful to the human body, and safety and health in a working environment when NMP is used has become a problem in the industry. For example, in Europe, REACH regulations classify NMP as a substance of very high concern (SVHC) and regulate the use thereof. Therefore, there is a growing need for alternative solvents for NMP in usage applications using resins such as polyamideimides, polyamides, and polyimides.

For example, N-ethyl-2-pyrrolidone (NEP) is known as an alternative solvent for NMP. However, due to the similarity in molecular structure between NEP and NMP, use of NEP is likely to be regulated in the future in the same way as NMP.

### PRIOR ART DOCUMENTS

### PATENT DOCUMENT

Patent Document 1: JP 2012-241082 A

### SUMMARY OF THE INVENTION

### PROBLEMS TO BE SOLVED BY THE INVENTION

In the conventional technology, when an alternative solvent for NMP is used, the properties tend to be degraded compared with a resin composition using NMP, and a sufficiently satisfactory property level is not reached.

Therefore, embodiments of the present invention provide a resin composition that substantially does not contain NMP as a solvent and can realize the same level of properties as a conventional resin composition using NMP. In particular, one embodiment of the present invention provides a resin composition that can suppress the occurrence of whitening after application and obtain excellent coating film properties.

### MEANS TO SOLVE THE PROBLEMS

In view of the above situation, inventors of the present invention have performed various investigations on alternative solvents for NMP. As a result, the inventors have found that a combination of specific organic solvents can suppress the occurrence of whitening after application and provide excellent coating film properties, leading to the completion of the present invention. That is, the embodiments of the present invention relate to the following. However, the present invention is not limited to the following embodiments.

One embodiment relates to a resin composition including: at least one resin selected from the group consisting of a polyamide, a polyamideimide, a polyimide, and a polyamic acid; at least one solvent A having a lactone structure; and at least one solvent B that is compatible with the solvent A, in which a moisture content in the solvent B after storage for 3 hours at 30°C and 60% RH is 2% by mass or less.

One embodiment relates to a resin composition including: at least one resin selected from the group consisting of a polyamide, a polyamideimide, a polyimide, and a polyamic acid; at least one solvent A having a lactone structure; and at least one solvent B that is compatible with the solvent A, in which the solvent B is selected from the group consisting of a glycol ester solvent and a cyclic ketone solvent.

In the above embodiment, a mass ratio of the solvent A/the solvent B is preferably in a range from 90/10 to 10/90.

Boiling points of both the solvent A and the solvent B are preferably in a range from 100 to 250°C.

The resin preferably includes a polyamideimide resin having a structural unit represented by formula (1) below.

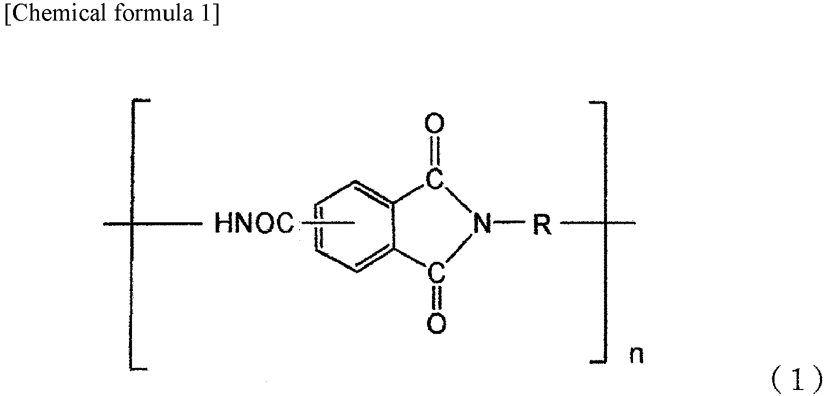

Where R represents a residue obtained by excluding an amino group from a diamine compound or a residue obtained by excluding an isocyanate group from a diisocyanate compound, and n represents an integer of 1 or more.

In the above embodiment, the resin is preferably a resin having a structural unit represented by formula (Ia) below.

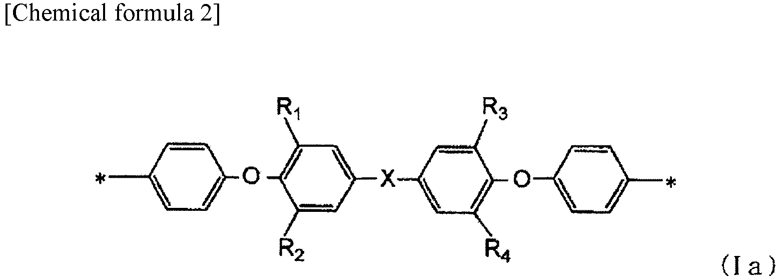

Where R₁ to R₄ each independently represents a hydrogen atom or one or more substituents selected from the group consisting of an alkyl group of 1 to 9 carbon atoms, an alkoxy group of 1 to 9 carbon atoms, and a halogen atom.

X is a single bond or a divalent organic group selected from the following.

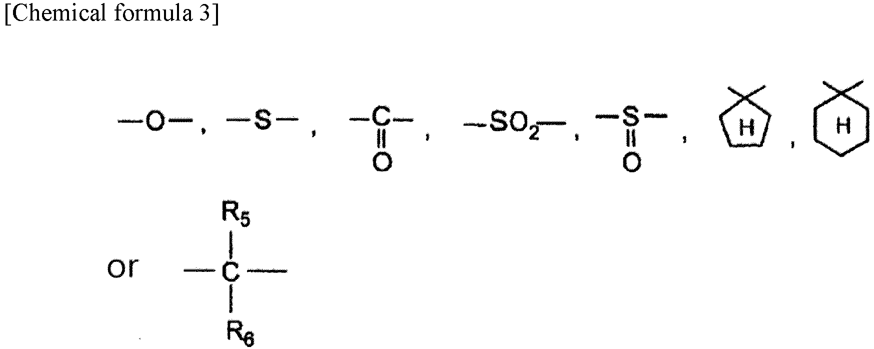

Where R₅ and R₆ each independently represents a hydrogen atom or one or more substituents selected from the group consisting of an alkyl group of 1 to 9 carbon atoms, a trifluoromethyl group, a trichloromethyl group, and a phenyl group.

In the above embodiment, the resin is preferably a resin having a structural unit represented by formula (IIa) or a structural unit represented by formula (VIa).

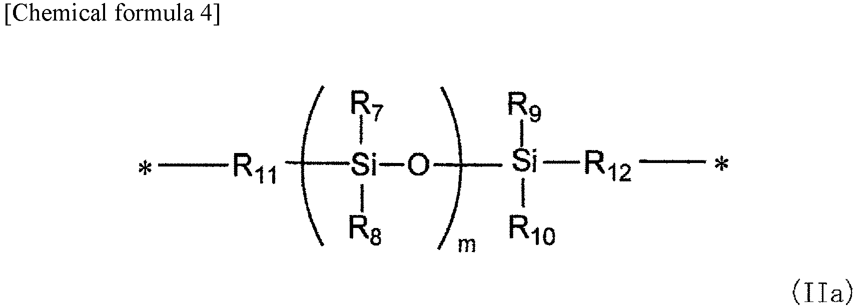

Where R₇ to R₁₀ each independently represents a hydrogen atom or a substituent, R₁₁ and R₁₂ each independently represents a divalent hydrocarbon group, and m is an integer of 1 or more.

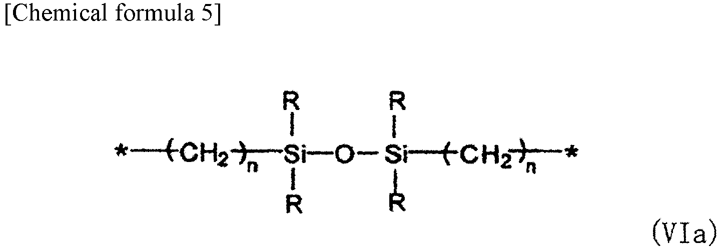

Where each R independently represents a hydrogen atom or at least one substituent selected from the group consisting of an alkyl group of 1 to 9 carbon atoms, an alkoxy group of 1 to 9 carbon atoms, and a halogen atom, and n represents an integer of 1 to 6.

In the embodiment, the resin is preferably a resin having a structural unit represented by formula (IVa) below.

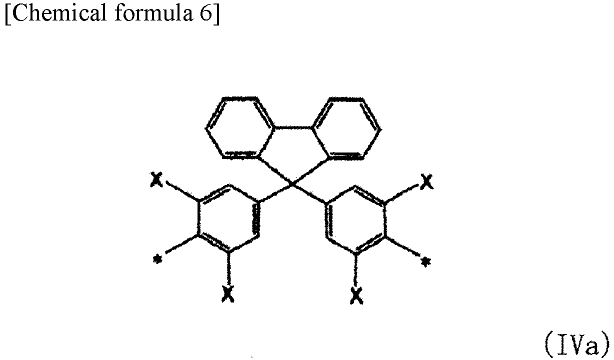

Where each X independently represents a hydrogen atom or at least one substituent selected from the group consisting of a halogen atom, an alkyl group of 1 to 9 carbon atoms, an alkoxy group of 1 to 9 carbon atoms, and a hydroxyalkyl group of 1 to 9 carbon atoms.

The resin preferably further includes at least one structural unit selected from the group consisting of a structural unit represented by formula (Va) below, a structural unit represented by formula (Vb) below, and a structural unit represented by formula (Vc) below.

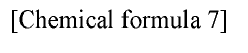

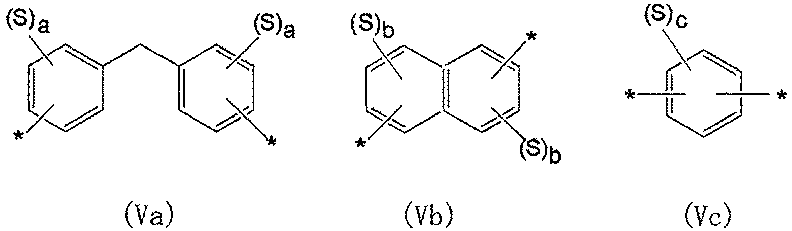

Where each S independently represents an alkyl group of 1 to 3 carbon atoms, a represents an integer of 0 to 4, b represents an integer of 0 to 3, and c represents an integer of 0 to 4.

Another embodiment relates to a method of manufacturing a semiconductor device including: forming a coating film using the resin composition of the above embodiment.

The coating film is preferably formed before a sealing step.

The coating film is preferably a primer layer or an insulating layer.

### EFFECTS OF THE INVENTION

According to the embodiments of the present invention, it is possible to provide a resin composition that substantially does not contain NMP as a solvent and can realize the same level of properties as a conventional resin composition using NMP. The resin composition according to the embodiments of the present invention hardly causes whitening after application and can be suitably used for various usage applications such as paints and semiconductor device materials.

### EMBODIMENTS FOR CARRYING OUT THE INVENTION

Embodiments of the present invention will be described below. However, the present invention is not limited to the following embodiments, and includes various embodiments.

### <Resin composition>

A resin composition, which is an embodiment of the present invention, contains an organic solvent other than NMP and at least one resin selected from the group consisting of a polyamideimide, a polyimide, a polyamide, and a polyamic acid. "Resin composition" is sometimes used to mean the equivalent of "varnish" or "paint".

The above resin composition substantially does not contain NMP. In one embodiment, the expression "substantially does not contain NMP" may mean that, relative to the total mass of the resin composition, the amount of NMP is preferably less than 0.3% by mass. The amount of NMP may be preferably less than 0.2% by mass, and more preferably less than 0.1% by mass. Therefore, for example, NMP that is mixed in a process such as resin synthesis and remains in the resin composition is not completely excluded.

### (Organic solvent)

In the above resin composition, the organic solvent contains solvent A and solvent B, which will be described later. In one embodiment, the solvent A is at least one solvent having a lactone structure (cyclic ester structure). It is preferable that at least the solvent A dissolves at least one resin selected from the group consisting of a polyamide, a polyamideimide, a polyimide, and a polyamic acid.

The above term "dissolve" means that when a solution obtained by adding the solvent A to the resin and stirring the mixture at room temperature is visually confirmed, there is no precipitate, no turbidity, and the entire solution becomes transparent. Here, the above "room temperature" may be in the range of substantially 10 to 40°C and preferably 20 to 30°C. In one embodiment, it is preferable that 100 mL of the solvent A can dissolve up to 30 mg of resin powder. The above "stirring" may be performed at 40 to 50 rpm using a stirrer such as a mix rotor.

Meanwhile, the solvent B is at least one solvent that is compatible with the solvent A, and the moisture content after storing the dried solvent B for 3 hours at 30°C and 60% RH (relative humidity) is 2% by mass or less. The above moisture content is a measurement value of the solvent B after storing 30 g of the dried solvent B in a cylindrical container having a 2 cm radius for 3 hours at 30°C and 60% RH. The moisture content is preferably 2% by mass or less, more preferably 1.5% by mass or less, and even more preferably 1% by mass or less. If the above moisture content of the solvent B is 2% by mass or less, whitening (resin precipitation) of the resin composition can be easily suppressed, and a uniform coating film can be easily obtained.

The above moisture content means the proportion of moisture content in the solvent B based on the total mass of the solvent B. In the present specification, the content is a measurement value obtained by using a Karl Fischer moisture meter (moisture meter) according to a Karl Fischer coulometric titration method at room temperature. For example, a moisture meter CA-21 manufactured by Nittoseiko Analytech Co., Ltd. can be used.

The compatibility between the solvent B and the solvent A is determined as follows. First, 10 mL of the solvent B is mixed with 10 mL of the solvent A in a colorless transparent glass container. Then these are stirred or dispersed at 25°C, and the resulting solution is placed in a stationary position for 10 minutes. Then, visual observation is performed for an interface between the solutions from the side of the glass container. If an interface is observed in the solutions, it is determined that "the solvents are not compatible". Meanwhile, if an interface is not observed in the solutions, it is determined that "the solvents are compatible". The stirring or dispersion when preparing the above solution may be performed under such conditions as holding the glass container in a hand and shaking the container up and down quickly about 10 times.

Specific examples of the solvent A include lactones such as γ-butyrolactone (GBL), γ-valerolactone, γ-caprolactone, γ-heptalactone, α-acetyl-γ-butyrolactone, and ε-caprolactone. In one embodiment, the solvent A preferably contains at least one selected from the group consisting of γ-butyrolactone, γ-valerolactone, and γ-caprolactone, and more preferably contains at least γ-butyrolactone.

Meanwhile, the solvent B is at least one solvent that is compatible with the solvent A, as described above, and there are no limitations on the solvent as long as the moisture content after storing the solvent for 3 hours at 30°C and 60% RH (relative humidity) is 2% by mass or less.

Specific examples of the solvent B include aromatic hydrocarbon solvents, aliphatic hydrocarbon solvents, ester solvents (except for cyclic ester solvents), ether solvents, and ketone solvents. One of these may be used alone, or a combination of two or more may be used.

More specifically, the aromatic hydrocarbon solvent may be, for example, xylene, ethylbenzene, tetramethylbenzene, or the like.

The aliphatic hydrocarbon solvent may be, for example, hexane, octane, decane, or the like, or may be a mixture thereof such as petroleum ether, white gasoline, and solvent naphtha.

The ester solvent (except for cyclic ester solvent) may be an alkyl acetate such as ethyl acetate, propyl acetate, or butyl acetate. Further, the ester solvent may be a glycol ester solvent. Specific examples include monoalkylene glycol monoalkyl ether monoacetates or polyalkylene glycol monoalkyl ether monoacetates such as ethylene glycol monomethyl ether acetate (butyl cellosolve acetate), diethylene glycol monomethyl ether monoacetate, diethylene glycol monoethyl ether monoacetate, triethylene glycol monoethyl ether monoacetate, diethylene glycol monobutyl ether monoacetate, propylene glycol monomethyl ether acetate, and butylene glycol monomethyl ether acetate.

Further, the ester solvent may be a polycarboxylic acid alkyl ester such as dialkyl glutarate, dialkyl succinate, and dialkyl adipate.

From thereamong, a glycol ester solvent is preferred, monoalkylene glycol monoalkyl ether monoacetate is more preferred, and ethylene glycol monomethyl ether acetate is even more preferred.

The ether solvent may be an alkyl ether such as diethyl ether or ethyl butyl ether. Further, the solvent may be a glycol ether such as ethylene glycol dimethyl ether, ethylene glycol diethyl ether, diethylene glycol methylethyl ether, diethylene glycol diethyl ether, dipropylene glycol dimethyl ether, dipropylene glycol diethyl ether, and triethylene glycol diethyl ether. Furthermore, the solvent may be a cyclic ether such as tetrahydrofuran.

The ketone solvent may be an acyclic ketone such as acetone and methylethyl ketone and a cyclic ketone such as cyclopentanone, cyclohexanone, and isophorone. From thereamong, cyclic ketone solvents are preferred, and cyclopentanone or cyclohexanone is more preferred.

As the solvent B, an above-described solvent may be used alone or a combination of two or more may be used. In one embodiment, the solvent B preferably contains at least one selected from the group consisting of a glycol ester solvent (hereinafter referred to as "solvent B1") and a cyclic ketone solvent (hereinafter referred to as "solvent B2"). In one embodiment, the solvent B more preferably contains one or more selected from the group consisting of ethylene glycol monomethyl ether acetate (butyl cellosolve acetate) (BuCA), cyclopentanone (CPN), and cyclohexanone (CHN).

Examples of a preferred combination of solvent A/solvent B include, but are not particularly limited to, GBL/CPN, GBL/CHN, and GBL/BuCA.

Although not constrained by theory, for example, GBL, which is an example of the solvent A, is a polar solvent that is similar to NMP but tends to be inferior in resin solubility compared to NMP. Therefore, it is thought that whitening is likely to occur after application in a resin compositions using GBL. Meanwhile, the solvent B has low water absorption, and the moisture content after storing the solvent for 3 hours at 30°C and 60% RH, for example, is 2% by mass or less. Therefore, it is presumed that the water absorption of the solvent A can be suppressed by using the solvent A in combination with the solvent B having low water absorption. It is also presumed that the coating film properties can be enhanced by using the solvent A in combination with the solvent B.

The mass ratio of solvent A/solvent B can be adjusted appropriately from the viewpoint of the resin solubility and water absorption. In one embodiment, the mass ratio of solvent A/solvent B can be from 90/10 to 10/90. A more detailed description will be given below regarding the case where the resin is resin (A) or resin (B) described later.

In one embodiment, if solvent A/solvent B is a cyclic ketone solvent (B2) such as GBL/CPN or GBL/CHN, the mass ratio of solvent A/solvent B2 is preferably from 90/10 to 10/90. The above mass ratio is more preferably from 70/30 to 30/70 and even more preferably from 60/40 to 40/60. Such a combination tends to enhance the surface roughness of the coating film after drying, or to prevent the nozzle from drying when dispensed coating is carried out.

In another embodiment, if solvent A/solvent B is a glycol ester solvent (B1) such as GBL/BuCA, the mass ratio of solvent A/solvent B 1 is preferably from 90/10 to 60/40 and more preferably from 90/10 to 70/30. The above mass ratio is even more preferably from 85/15 to 75/25. Further, the mass ratio of solvent A/solvent B1 is preferably from 90/10 to 75/25. Such a combination tends to reduce the water absorption and make it easier to suppress the precipitation of resin during the formation of a coating film.

In one embodiment, the resin composition may further contain a solvent that is different from the above solvents A and B to the extent that the desired properties are not degraded. Based on the total mass of the solvent, the total amount of the solvent A and the solvent B is preferably 90% by mass or more, more preferably 95% by mass or more, and even more preferably 99.7% by mass or more.

In one embodiment, the boiling points of both the solvent A and solvent B are preferably from 100 to 250°C from the viewpoint of drying properties and the like during coating film formation. The above boiling points are more preferably from 130 to 220°C and even more preferably from 150 to 210°C. Among the solvents exemplified above, from the viewpoint of the boiling point, the solvent A is preferably γ-butyrolactone (GBL, boiling point 204°C). Meanwhile, the solvent B is preferably cyclopentanone (CPN, boiling point 131°C), cyclohexanone (CHN, boiling point 156°C), or butyl cellosolve acetate (BuCA, boiling point 192°C).

When these solvents are used, the boiling point is similar to or lower than that of NMP, and therefore it is possible to easily obtain excellent drying properties when a coating film is formed as in the case where NMP is used.

### (Resin)

In the resin composition of the above embodiment, the resin may be a conventional resin known in the technical field, but the composition at least preferably contains at least one resin selected from the group consisting of a polyamideimide, a polyimide, a polyamide, and a polyamic acid. These resins have excellent heat resistance, toughness, and flexibility. Therefore, a resin composition using these resins can easily form, for example, a coating film having favorable properties as an insulating layer or a primer layer of a semiconductor element.

A polyamideimide, a polyimide, a polyamide, and a polyamic acid can be synthesized according to a conventional method known in the technical field. In the resin composition of the above embodiment, at least one resin selected from the group consisting of a polyamideimide, a polyimide, a polyamide, and a polyamic acid may contain, for example, a structural unit represented by formula (Ia) below. Further, the resin may contain a structural unit represented by formula (IIa) below.

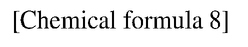

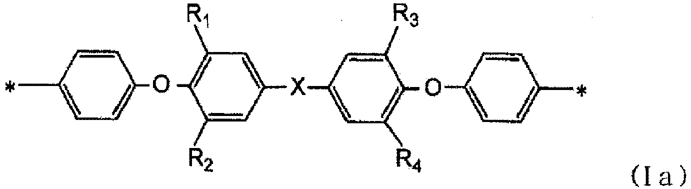

In the formula, R₁ to R₄ each independently represents a hydrogen atom or one or more substituents selected from the group consisting of alkyl groups of 1 to 9 carbon atoms, alkoxy groups of 1 to 9 carbon atoms, and halogen atoms.

The above alkyl or alkoxy group may have a linear, branched, or cyclic structure. The above alkyl and alkoxy groups more preferably contain 1 to 6 carbon atoms and even more preferably 1 to 3 carbon atoms.

The halogen atom may be a fluorine atom, a chlorine atom, or a bromine atom.

X represents a single bond or a divalent organic group selected from the following. In one embodiment, X is preferably -CR₅R₆-.

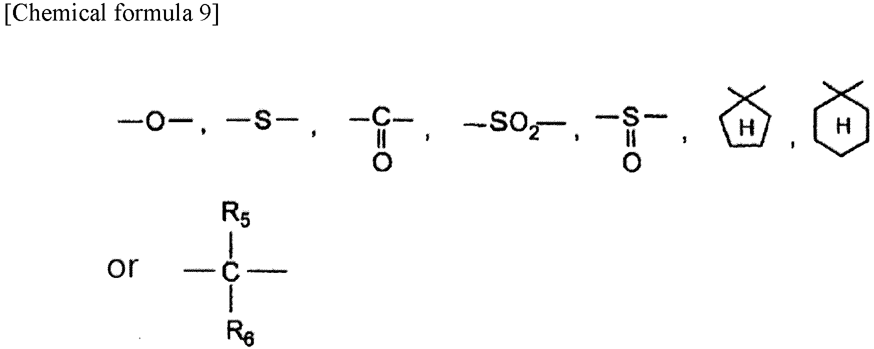

In the formula, R₅ and R₆ each independently represents a hydrogen atom or one or more substituents selected from the group consisting of alkyl groups of 1 to 9 carbon atoms, a trifluoromethyl group, a trichloromethyl group, and a phenyl group.

The above alkyl group may have a linear, branched, or cyclic structure. In one embodiment, in the formula, R₅ and R₆ each independently represents preferably alkyl groups of 1 to 6 carbon atoms, more preferably alkyl groups of 1 to 3 carbon atoms, and even more preferably alkyl groups of 1 or 2 carbon atoms.

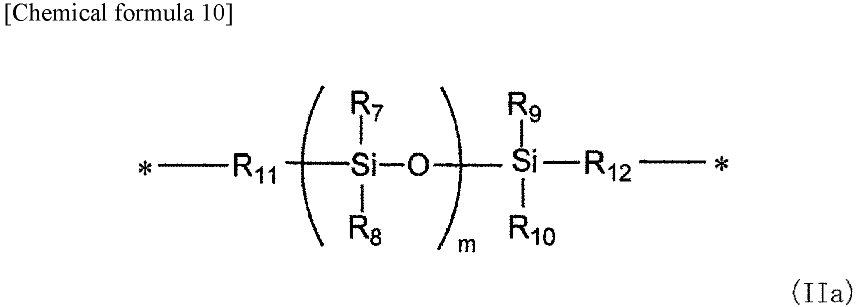

In the formula, R₇ to R₁₀ each independently represents a hydrogen atom or a substituent, R₁₁ and R₁₂ each independently represents a divalent hydrocarbon group, and m represents an integer of 1 or more.

In one embodiment, R₇ to R₁₀ above each independently represents preferably a substituent. The substituent may be at least one selected from the group consisting of alkyl groups of 1 to 9 carbon atoms, alkoxy groups of 1 to 9 carbon atoms, and a halogen atom. The alkyl groups and the alkoxy groups may have a linear, branched, or cyclic structure. R₇ to R₁₀ more preferably represent alkyl groups of 1 to 6 carbon atoms or phenyl groups. The hydrogen atoms in the above phenyl groups may be replaced by alkyl groups of 1 to 6 carbon atoms. In one embodiment, R₇ to R₁₀ each preferably represents alkyl groups of 1 to 6 carbon atoms and more preferably alkyl groups of 1 to 3 carbon atoms.

R₁₁ and R₁₂ above may each independently represent alkylene groups of 1 to 9 carbon atoms or a phenylene group. The hydrogen atoms in the phenylene group may be replaced by alkyl groups of 1 to 3 carbon atoms. The above alkylene group may have a linear, branched, or cyclic structure. In one embodiment, R₁₁ and R₁₂ each independently represents preferably linear alkylene groups of 1 to 6 carbon atoms, more preferably alkylene groups of 2 to 5 carbon atoms, and even more preferably alkylene groups of 3 or 4 carbon atoms.

In the above formula, m is preferably from 1 to 100, more preferably from 1 to 40, and even more preferably from 1 to 10.

In one embodiment, the resin may further be a polyamideimide resin having a structural unit represented by formula (IIIa) below.

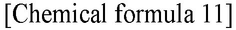

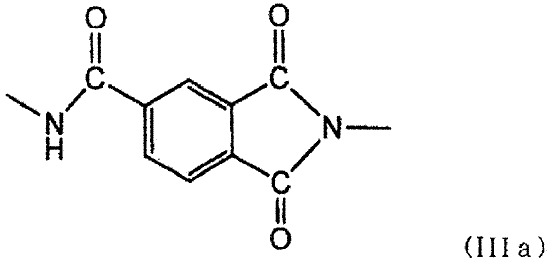

In one embodiment, at least one resin selected from the group consisting of a polyamideimide, a polyimide, a polyamide, and a polyamic acid may contain, for example, a structural unit having a cardo structure fluorene skeleton represented by formula (IVa) below. The resin may also contain at least one selected from the group consisting of structural units represented by formulas (Va), (Vb), and (Vc) below.

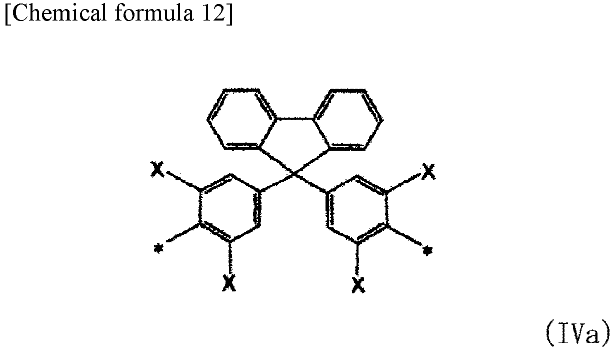

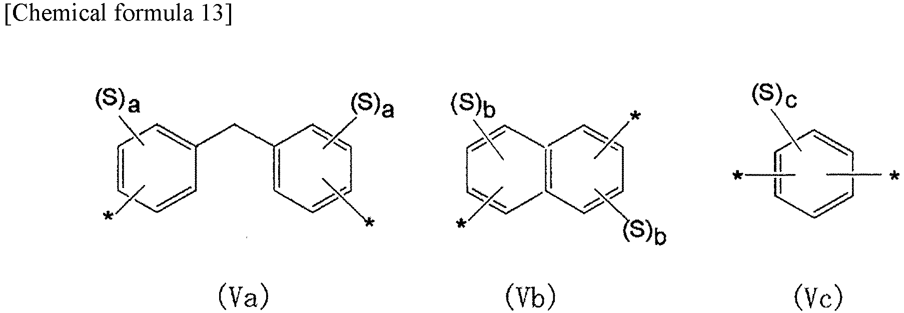

In the above formula (IVa), each X independently represents a hydrogen atom or at least one substituent selected from the group consisting of halogen atoms, alkyl groups of 1 to 9 carbon atoms, and alkoxy groups and hydroxyalkyl groups of 1 to 9 carbon atoms.

The halogen atom may be a fluorine atom, a chlorine atom, or a bromine atom. The alkyl and alkoxy groups may have a linear, branched, or cyclic structure.

In one embodiment, each X independently represents preferably a hydrogen atom, an alkyl group of 1 to 9 carbon atoms, or a halogen atom. The above alkyl group is more preferably an alkyl group of 1 to 6 carbon atoms and even more preferably an alkyl group of 1 to 3 carbon atoms. In one embodiment, each X is preferably a hydrogen atom.

In the above formulas (Va), (Vb), and (Vc), each S independently represents an alkyl group of 1 to 3 carbon atoms, a represents an integer of 0 to 4, b represents an integer of 0 to 3, and c represents an integer of 0 to 4.

In one embodiment, the resin may further contain a structural unit (VIa) represented by the following formula.

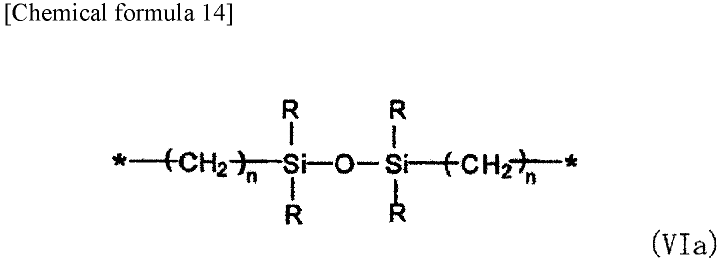

In the formula, each R independently represents a hydrogen atom or at least one substituent selected from the group consisting of alkyl groups of 1 to 9 carbon atoms, alkoxy groups of 1 to 9 carbon atoms, and halogen atoms, and n represents an integer of 1 to 6.

The halogen atom may be a fluorine atom, a chlorine atom, or a bromine atom. The alkyl and alkoxy groups may have a linear, branched, or cyclic structure.

In one embodiment, each R independently represents preferably an alkyl group of 1 to 9 carbon atoms, more preferably an alkyl group of 1 to 6 carbon atoms, and even more preferably an alkyl group of 1 to 3 carbon atoms.

n is preferably an integer of 2 to 4, and more preferably 3 or 4.

In the above embodiment, the resin is preferably a resin containing a structural unit represented by formula (Ia) above and a structural unit represented by formula (IIa) or (VIa) above. The resin is more preferably a polyamideimide resin containing a structural unit represented by formula (Ia) above and a structural unit represented by formula (IIa) or (VIa) above. The resin is even more preferably a polyamideimide resin containing a structural unit represented by formula (Ia) above, a structural unit represented by formula (IIa) or (VIa) above, and a structural unit represented by formula (IIIa) below.

In the above embodiment, the resin is preferably a resin containing a structural unit represented by formula (IVa) above and a structural unit represented by any one of formulas (Va), (Vb), and (Vc) above. The resin is more preferably a resin containing a structural unit represented by formula (IVa) above, a structural unit represented by any one of formulas (Va), (Vb), and (Vc) above, and a structural unit represented by formula (IIa) or (VIa) above. The resin is more preferably a polyamideimide resin containing a structural unit represented by formula (IVa) above, a structural unit represented by any one of formulas (Va), (Vb), and (Vc) above, and, if necessary, a structural unit represented by formula (IIa) or (VIa), and even more preferably is a polyamideimide resin containing a structural unit represented by formula (IIIa) below.

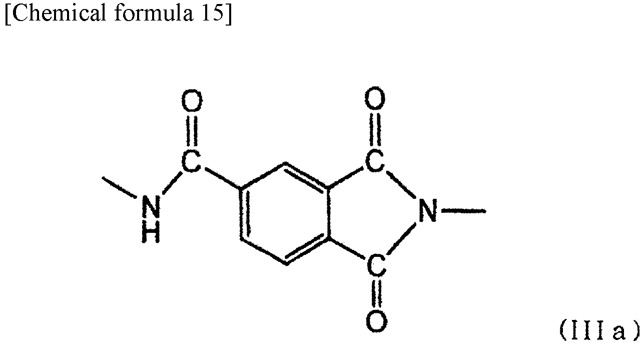

As another embodiment of a polyamideimide resin (B) having the cardo structure fluorene skeleton described above, the resin may have a structural unit represented by formula (Vd) below instead of the structural unit represented by any one of formulas (Va), (Vb), and (Vc) above.

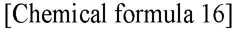

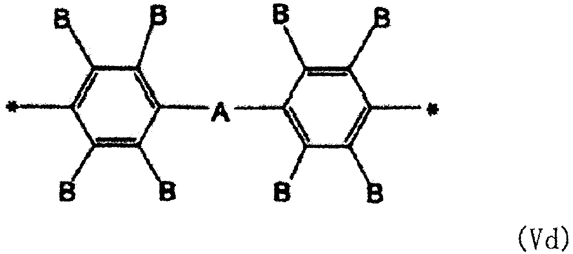

In the above formula, A represents a divalent group or a single bond. The divalent group is an oxygen atom, a sulfur atom, or any one group selected from the group consisting of a carbonyl group, sulfonyl group, dimethylmethylene group, hexafluoroisopropylidene group, amide group, ester group, diphenyl ketone group, 1,4-phenyleneoxy group, 1,4-biphenyleneoxy group, sulfonylbis(1,4-phenyleneoxy) group, isopropylidenebis(1,4-phenyleneoxy) group, and hexafluoroisopropylidenebis(1,4-phenyleneoxy) group. In one embodiment, A is preferably an oxygen atom.

Each B independently represents a hydrogen atom or at least one substituent selected from the group consisting of an alkyl group of 1 to 9 carbon atoms, alkoxy group of 1 to 9 carbon atoms, a trifluoromethyl group, a carboxylic acid group, a hydroxy group, and a halogen atom. The halogen atoms may be a fluorine atom, a chlorine atom, or a bromine atom.

In one embodiment, each B independently represents preferably a hydrogen atom or an alkyl group of 1 to 9 carbon atoms. The above alkyl group is more preferably an alkyl group of 1 to 6 carbon atoms and even more preferably an alkyl group of 1 to 3 carbon atoms.

### (Polyamideimide)

Polyamideimides will be described in more detail below as an example of a resin.

A polyamideimide is a resin obtained by reacting a diamine compound or diisocyanate compound with an acid component containing tribasic acid anhydride or tribasic acid halide. Here, each raw material compound may be used by combining a plurality of raw material compounds in a discretionary manner.

The diamine compound or diisocyanate compound may be, for example, an aromatic diamine or an aromatic diisocyanate, or an aliphatic diamine or an aliphatic diisocyanate. An aromatic diamine or an aromatic diisocyanate is preferred.

Examples of the aromatic diamine (diisocyanate) include 2,7-diaminofluorene, 9,9-bis[4-(4-aminophenoxy)phenyl]-9H-fluorene, 2,2'-ditrifluoromethyl-4,4'-diaminobiphenyl, 4,4'-diaminodiphenylsulfone, 3,3'-diaminodiphenylsulfone, 4,4'-diamino-2,2'-biphenyldisulfonic acid, 3,4'-diaminodiphenyl ether, bis[4-(4-aminophenoxy)phenyl]sulfone, bis[4-(3-aminophenoxy)phenyl]sulfone, 2,2-bis[4-(4-aminophenoxy)phenyl]propane, 1,4-bis(4-aminophenoxy)benzene, 1,3-bis(3-aminophenoxy)benzene, 2,2-bis(4-aminophenyl)hexafluoropropane, 1,4-phenylenediamine, 2-chloro-1,4-phenylenediamine, 1,3-phenylenediamine, 4,4'-diaminobenzophenone, 3,3'-diaminobenzophenone, 3,4'-diaminodiphenylmethane, 4,4'-diaminobenzanilide, 3,6-diaminocarbazole, 4,4'-bis(4-aminophenoxy)biphenyl, 2-trifluoromethyl-1,4-diaminobenzene, 2,2-bis[4-(4-aminophenoxy)phenyl]hexafluoropropane, 2,2-bis(4-aminophenyl)hexafluoropropane, 2,2'-bis(trifluoromethyl)benzidine, 2,2'-ditrifluoromethyl-4,4'-diaminobiphenyl ether, 4-aminophenyl sulfide, 4,4'-diamino-3,3'-dimethylbiphenyl, naphthalenediamine, and naphthalenediisocyanate.

Examples of the aliphatic diamine (diisocyanate) include 1,4-cyclohexanediamine, 1,3-cyclohexanediamine, 1,4-di(aminomethyl)cyclohexane, 1,3-bis(aminomethyl)cyclohexane, bis(aminomethyl)norbornane, 4,4'-methylenebis(cyclohexylamine), hexamethylenediamine, and hexamethylenediisocyanate.

In one embodiment, it is preferred to use a diamine or diisocyanate compound that can derive structural units represented by the previously described formulas (Ia), (IIa), (IVa), (Va) to (Vd), and (VIa).

For example, a diamine or diisocyanate compound that can derive a structural unit represented by formula (IVa) is represented by formula (IV) below. In the formula, X is as described above, and Y represents an amino group (-NH₂) or an isocyanate group (-NCO).

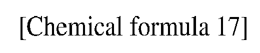

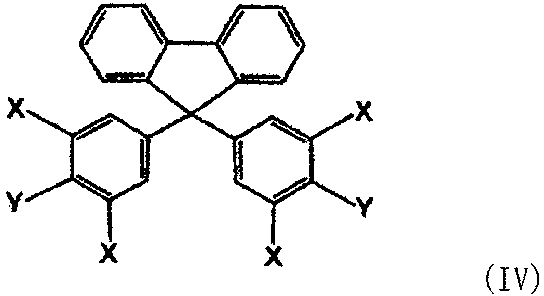

Specific examples of the compound represented by formula (IV) above include 9,9-bis(4-aminophenyl)fluorene, 9,9-bis(4-amino-3-methylphenyl)fluorene,9,9-bis(4-amino-3-chlorophenyl)fluorene, and 9,9-bis(4-amino-3-fluorophenyl)fluorine. These can be suitably used as diamine compounds that can derive structural units (IVa).

Further, specific examples of compounds that can derive structural units represented by formula (VIa) include 1,3-bis(3-aminopropyl)1,1,3,3-tetramethyldisiloxane, 1,3-bis(2-aminoethyl)1,1,3,3-tetramethyldisiloxane, 1,3-bis(aminomethyl)1,1,3,3-tetramethyldisiloxane, 1,3-bis(4-aminobutyl)1,1,3,3-tetramethyldisiloxane, 1,3-bis(5-aminopentyl)1,1,3,3-tetramethyldisiloxane, and 1,3-bis(6-aminohexyl)1,1,3,3-tetramethyldisiloxane.

In one embodiment, a polyamideimide resin (A) preferably has structural units represented by formulas (Ia) and (IIa). In the polyamideimide resin (A), the total of the proportion of the structural units represented by formula (Ia) and the proportion of the structural units represented by formula (IIa) relative to the total amount of structural units derived from the diamine compound or the diisocyanate compound may be more than 80 mol% or may be 100 mol%.

In addition, as another embodiment, the polyamideimide resin (B) may be a resin having structural units represented by formula (IIa) and structural units represented by formula (IVa), and the resin preferably has at least one structural unit selected from the group consisting of structural units represented by formulas (Va), (Vb), and (Vc). In the polyamideimide resin (B), the total of the proportion of the structural units represented by formula (IIa), the proportion of the structural units represented by formula (IVa), and the proportion of at least one structural unit selected from the group consisting of structural units represented by formulas (Va), (Vb), and (Vc) relative to the total amount of structural units derived from the diamine compound or the diisocyanate compound may be more than 80 mol% or may be 100 mol%. Here, the proportion of the structural units represented by formula (IVa) relative to the total amount of structural units derived from the diamine compound or the diisocyanate compound may be preferably 10 to 90 mol%, more preferably 30 to 70 mol%, and even more preferably 40 to 60 mol%. By adjusting the proportion of the structural units represented by formula (IVa) to be within the above ranges, it becomes easy to achieve balance with solubility while increasing the heat resistance of the resin.

In both the polyamideimide resins (A) and (B) of the above embodiment, the proportion of the structural units represented by formula (IIa) relative to the total amount of structural units derived from the diamine compound or the diisocyanate compound may be preferably 1 to 50 mol%, more preferably 3 to 30 mol%, and even more preferably 5 to 10 mol%.

In one embodiment, another diamine compound or diisocyanate compound that can derive a structural unit other than the structural units represented by formulas (Ia), (IIa), (IVa), (Va) to (Vd), and (VIa) may be used in combination to produce the polyamideimide resin. The proportion of the structural units derived from the other diamine compound or diisocyanate compound relative to the total amount of structural units derived from the diamine compound or the diisocyanate compound is preferably 20 mol% or less. The proportion of the structural units derived from the above other compound is more preferably 10 mol% or less and even more preferably 5 mol% or less.

Although there are no particular limitations, as the tribasic acid anhydride, aromatic tribasic acid anhydride is preferably used, and especially trimellitic anhydride is preferable. Although there are no particular limitations, as the tribasic acid halide, tribasic acid chloride is used, and further aromatic tribasic acid chloride is preferably used. Examples include trimellitic anhydride chloride (anhydrous trimellitic acid chloride) and the like. It is preferable to use trimellitic anhydride or the like from the viewpoint of reducing the load on the environment.

From this type of viewpoint, in one embodiment, the above polyamideimide resins (A) and (B) preferably further contain a structural unit which is derived from trimellitic anhydride and is represented by formula (IIIa) above as a structural unit derived from tribasic acid anhydride. Based on the total amount of structural units derived from the acid component, the proportion of the structural units represented by formula (IIIa) above is preferably 50 mol% or more, more preferably 70 mol% or more, and even more preferably 80 mol%. In one embodiment, based on the total amount of structural units derived from the acid component, the proportion of the structural units represented by formula (IIIa) above may be 100 mol%.

In addition to the above tribasic acid anhydride (or tribasic acid halide), saturated or unsaturated polybasic acids such as dicarboxylic acid and tetracarboxylic dianhydride can be used as the acid component to the extent that the properties of the polyamideimide are not degraded.

Although there are no particular limitations, examples of the dicarboxylic acids include terephthalic acid, isophthalic acid, adipic acid, and sebacic acid. Although there are no particular limitations, examples of tetracarboxylic dianhydride include pyromellitic dianhydride, benzophenone tetracarboxylic dianhydride, and biphenyltetracarboxylic acid dianhydride. One of these may be used alone or a plurality of types of acid components may be used in any combination.

From the viewpoint of preserving the properties of the polyamideimide, the total amount of carboxylic acid other than tribasic acid (dicarboxylic and tetracarboxylic acids) relative to all carboxylic acid is preferably in the range of from 0 to 50 mol% and more preferably in the range from 0 to 30 mol%.

The usage ratio between the diamine compound (or diisocyanate compound) and the acid component (total amount of tribasic acid anhydride or tribasic acid anhydride halide, and dicarboxylic acid and tetracarboxylic dianhydride used as needed) is preferably adjusted from the viewpoints of the molecular weight and degree of crosslinking of the polyamideimide produced. For example, the amount of the diamine compound (or diisocyanate compound) relative to 1.0 mol of the total acid component is preferably within a range from 0.8 to 1.1 mol, more preferably from 0.95 to 1.08 mol, especially even more preferably from 1.0 to 1.05 mol.

A polyamideimide is a resin that has amide and imide bonds in a molecular skeleton, and is obtained, for example, by a reaction between the diamine compound or the diisocyanate compound and the acid component such as a tricarboxylic anhydride. In one embodiment, the polyamideimide preferably has a structural unit represented by formula (1) below.

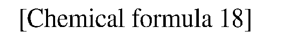

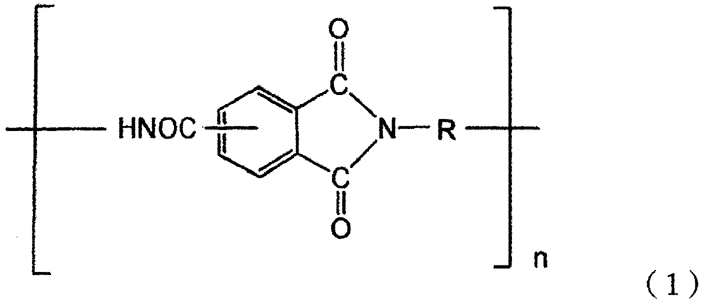

In the formula, R represents a residue obtained by excluding the amino group from the diamine compound or a residue obtained by excluding the isocyanate group from the diisocyanate compound, and n represents an integer of 1 or more.

In one embodiment, R may represent the structural unit represented by formula (Ia) and the structural unit represented by formula (IIa) described above. A polyamideimide (A) having such a structure can be obtained, for example, by reacting 2,2-bis[4-(4-aminophenoxy)phenyl]propane, 1,3-bis(3-aminopropyl)1,1,3,3-tetramethyldisiloxane, and trimellitic anhydride chloride.

In another embodiment, R may represent the structural unit represented by formula (IVa), the structural unit represented by any one of formulas (Va), (Vb), and (Vc), and the structural unit represented by formula (VIa) described above. A polyamideimide (B) having such a structure can be obtained, for example, by reacting 9,9-bis(4-aminophenyl)fluorene, 4,4'-methylenebis[2,6-bis(1-methylethyl)benzenamine], and trimellitic anhydride chloride.

### (Method for producing polyamideimide resin)

The polyamideimide resin can be produced by conventional methods, and there are no particular limitations. For example, the polyamideimide resin can be produced via reaction between a diamine component and/or a diisocyanate component, and the acid component. The diamine component, the diisocyanate component, and the acid component are as described above. The reaction may be performed in a solvent-free state or in the presence of an organic solvent. The reaction temperature is preferably within a range from 25°C to 250°C. The reaction time may be set as appropriate in accordance with factors such as the batch scale and the reaction conditions being employed.

There are no particular limitations on the organic solvent (synthetic solvent) used during production of the polyamideimide resin. Examples of organic solvents that may be used include ether-based solvents such as diethylene glycol dimethyl ether, diethylene glycol diethyl ether, triethylene glycol dimethyl ether, and triethylene glycol diethyl ether, sulfur-containing solvents such as dimethyl sulfoxide, diethylsulfoxide, dimethylsulfone, and sulfolane, cyclic ester-based (lactone-based) solvents such as γ-butyrolactone, acyclic ester-based solvents such as cellosolve acetate, ketone-based solvents such as cyclohexanone and methyl ethyl ketone, nitrogen-containing solvents such as N-methyl-2-pyrrolidone, dimethylacetamide, and 1,3-dimethyl-3,4,5,6-tetrahydro-2(1H)-pyrimidinone, and aromatic hydrocarbon-based solvents such as toluene and xylene. One of these organic solvents may be used alone, or a combination of two or more organic solvents may be used.

In one embodiment, an organic solvent that is capable of dissolving the produced resin is preferably selected and used, and the use of a polar solvent is preferred. Although there are no particular limitations, specific examples of the polar solvent include nitrogen-containing solvents such as N-methyl-2-pyrrolidone, N,N-dimethylformamide, γ-butyrolactone, and N,N'-dimethylpropylene urea[1,3-dimethyl-3,4,5,6-tetrahydro pyridimine-2(1H)-one], dimethyl sulfoxide, diethylene glycol dimethyl ether, triethylene glycol dimethyl ether, and sulfolane. From thereamong, a nitrogen-containing solvent is preferred.

Although the amount used of the synthetic solvent is not particularly limited, the amount used relative to a total of 100 parts by mass of the acid component and the diamine or diisocyanate compound is preferably from 300 to 3,500 parts by weight/parts by mass, and more preferably from 400 to 2,000 parts by weight/parts by mass.

Generally, the synthetic solvent is removed after the synthesis of the resin, in accordance with a well-known technique, and the resin is collected. For example, the resin is obtained by adding water to a reaction liquid containing the resin to precipitate the resin and separating and collecting the precipitate. If necessary, a step for heating and drying the collected resin may be provided. Heating and drying may be performed in two or more steps or by heating the resin to a temperature within a range that does not cause phase transition or decomposition of the resin.

In one embodiment, the polyamideimide resin can be produced by means of a method in which a precursor of the polyamideimide resin is first produced by a reaction between the acid component and the diamine component, and this precursor is then subjected to dehydration cyclization to obtain the polyamideimide resin. However, there are no particular limitations on the precursor cyclization method, and any method that is known in the technical field may be used. For example, a heat cyclization method in which dehydration cyclization is achieved by conducting heating either at normal pressure or under reduced pressure, or a chemical cyclization method that uses a dehydration agent such as acetic anhydride, either in the presence of a catalyst or without a catalyst, may be used.

In the case of a heat cyclization method, cyclization is preferably performed while the water produced by the dehydration reaction is removed from the system. During the dehydration reaction, the reaction liquid may be heated to a temperature within a range from 80°C to 400°C, and preferably from 100°C to 250°C. Further, the water may also be removed by azeotropic distillation by using an organic solvent capable of forming an azeotrope with water, such as benzene, toluene, or xylene.

In the case of a chemical cyclization method, the reaction may be performed in the presence of a chemical dehydration agent, at a temperature within a range from 0°C to 120°C, and preferably from 10°C to 80°C. Examples of chemical dehydration agents that can be used favorably include acid anhydrides such as acetic anhydride, propionic anhydride, butyric anhydride, and benzoic anhydride, and carbodiimide compounds such as dicyclohexylcarbodiimide. During the reaction, a material that accelerates the cyclization reaction such as pyridine, isoquinoline, trimethylamine, triethylamine, aminopyridine, or imidazole is also preferably used in combination with the chemical dehydration agent.

The chemical dehydration agent may be used in a ratio of 90 to 600 mol% relative to the total amount of the diamine component, and a material that accelerates the cyclization reaction may be used in a ratio of 40 to 300 mol% relative to the total amount of the diamine component. Further, a dehydration catalyst, including a phosphorus compound such as triphenyl phosphite, tricyclohexyl phosphite, triphenyl phosphate, phosphoric acid, and phosphorus pentoxide, and a boron compound such as boric acid and boric anhydride, may also be used.

In one embodiment, from the viewpoint of ensuring the strength of the coating film, the weight average molecular weight (Mw) of the polyamideimide is preferably 30,000 or more, more preferably 35,000 or more, and even more preferably 38,000 or more. Meanwhile, from the viewpoint of ensuring the solubility in an organic solvent, the weight average molecular weight of the polyamideimide is preferably 150,000 or less, more preferably 130,000 or less, and even more preferably 120,000 or less. In the present specification, "Mw" values represent values measured relative to standard polystyrenes using gel permeation chromatography.

In one embodiment, the Mw of the polyamideimide is preferably in a range from 30,000 to 150,000. The above Mw is more preferably in a range from 35,000 to 130,000, and even more preferably in a range from 38,000 to 120,000. When a polyamideimide with an Mw in the above range is used, the viscosity change of the resin composition is suppressed and good storage stability can be easily obtained.

The Mw of the polyamideimide can be measured by performing sampling during resin synthesis using a gel permeation chromatograph (GPC) and a standard polystyrene calibration curve. The value can be controlled to the above preferred ranges by continuing the synthesis of the polyamideimide until the value reaches a desired number-average molecular weight. The measurement conditions for the GPC will be described later in the examples.

In one embodiment, the glass transition temperature (Tg) of the polyamideimide is preferably 120°C or higher, more preferably 150°C or higher, and even more preferably 200°C or higher. Meanwhile, from the viewpoint of solubility, the Tg is preferably 400°C or lower, more preferably 380°C or lower, and even more preferably 350°C or lower.

Here, the Tg is a value obtained by performing a dynamic viscoelasticity test using a film obtained by applying and then drying a resin (varnish) that has been dissolved in a solvent. The Tg is preferably in a range from 120 to 400°C, more preferably in a range from 150 to 380°C, and even more preferably in a range from 200 to 350°C.

Due to the polyamideimide having a Tg of 150°C or higher, it is possible to also obtain excellent reliability in a heat cycle test, for example. In addition, if a primer layer of a power semiconductor device is formed by applying the above resin composition, it is possible to easily suppress the softening of a coating film due to the generation of heat during driving and the lowering of adhesion.

By designing a resin with a skeleton in which the Tg of the polyamideimide is 350°C or lower, the solubility in a solvent can be ensured, which enhances the film production processability.

The content of the resin in the resin composition can be appropriately set depending on the usage application thereof. Although there are no particular limitations, in one embodiment, from the viewpoint of balance with other components, the content of the resin based on the total mass of the resin composition is preferably in a range from 5 to 30% by mass, and more preferably in a range from 10 to 25% by mass.

By increasing the resin content in the resin composition to 5% by mass or more, the application amount required to achieve the target film thickness after applying and then drying the resin composition is reduced, and therefore processability can be easily enhanced. Meanwhile, by reducing the resin content in the resin composition to 25% by mass or less, the viscosity stability during long-term storage of the resin composition can be easily enhanced.

In one embodiment, the viscosity of the resin composition is not particularly limited, but the viscosity may be in a range from 10 to 400 mPa·s, for example. The viscosity of the resin composition can be adjusted according to an application method. From this type of viewpoint, in one embodiment, the viscosity of the resin composition may be preferably in a range from 10 to 200 mPa·s, more preferably in a range from 10 to 150 mPa·s, and even more preferably in a range from 10 to 100 mPa·s. In another embodiment, the viscosity of the resin composition may be preferably in a range from 100 to 400 mPa s, more preferably in a range from 150 to 350 mPa·s, and even more preferably in a range from 200 to 300 mPa s.

Here, the above viscosity is a value obtained by measuring a varnish prepared by adjusting a content of a nonvolatile component (solid fraction component) in a solvent so as to be 1 to 20%, with the measurement being performed at 25°C and 10 rpm using an E-type viscometer.

If the viscosity measured at 10 rpm is 10 mPa·s or more, it is easy to ensure a sufficient film thickness at the time of application. Further, if the viscosity is 400 mPa s or less, it is easy to ensure a uniform film thickness at the time of application. The above viscosity can be measured using, for example, a viscometer (RE type) manufactured by Toki Sangyo Co., Ltd. For the measurement, the measurement temperature is set at 25°C ± 0.5°C, and then a solution of the resin composition of 1 mL to 1.5 mL is put into the viscometer, and the viscosity 10 minutes after the start of the measurement is recorded.

### (Other components)

In one embodiment, the above resin composition can contain optional components according to the intended use thereof in addition to the resin and organic solvent. For example, the resin composition can be preferably used as a paint. When the resin composition is used as a paint, optional components such as pigments, fillers, antifoaming agents, preservatives, and surfactants may be added as required. Further, the composition may contain a resin other than the above-described resin.

The above resin composition can be used for forming a film. A method of producing the film includes, for example, applying the resin composition of the above embodiment on a substrate, and drying the resin composition on the substrate by heating to obtain a coating film. In one embodiment, the above resin composition is preferably a resin composition containing a polyamide, a polyamideimide, or a polyimide. When this kind of resin composition is used, the above drying is preferably performed in two steps by heating the composition at a temperature in a range from 30 to 120°C and then heating the composition at a temperature in a range from 150 to 300°C. Since the resin composition of the above embodiment does not require a reaction such as imidization in the step of forming the coating film, the coating film can be obtained at a lower heating temperature compared to the case where a polyamic acid is applied and imidization is performed.

In one embodiment, the above resin composition may be varnish or paint used as a material of a semiconductor device. For example, the above paint may contain a polyamideimide, an organic solvent containing the above solvents A and B, and a silane coupling agent. This kind of paint (resin composition) can be suitably used as a coating film material for manufacturing a semiconductor device. From this type of viewpoint, one embodiment of the present invention relates to a semiconductor device having a coating film formed using the paint of the above embodiment.

A semiconductor device constituting one embodiment of the present invention can be obtained by means of a manufacturing method including forming a coating film using the paint (resin composition) of the above embodiment. For example, the above coating film can be formed by applying the paint on a constituent member of the semiconductor device, and heating and drying the paint. Conditions such as the heating temperature and heating time at the time of coating film formation (heating and drying) can be adjusted as appropriate.

In one embodiment, heating and drying is preferably performed in two steps. In the present embodiment, the heating and drying temperature in the first step may be preferably in a range from 30 to 120°C, and more preferably in a range from 50 to 100°C. The heating and drying temperature in the second step may be in a range from 150 to 300°C, more preferably in a range from 180 to 260°C, and even more preferably in a range from 200 to 230°C.

One embodiment of the present invention relates to a method of manufacturing a semiconductor device including using the paint (resin composition) of the above embodiment to form a coating film at least on a surface of a substrate on which a semiconductor element is mounted. The above paint can be used, for example, for forming coating films such as a protective layer of a semiconductor device, a primer layer that enhances adhesion between a sealing material and a substrate, and an insulating layer of the semiconductor device. The method of manufacturing the above semiconductor device may include a step of forming the above coating film and a sealing step. The step of forming the above coating film is as described above and may be performed before the sealing step, for example. Since the above paint substantially does not contain NMP, the paint has excellent operational safety, and additionally the combination of specific solvents suppresses the degradation of properties in comparison with a paint using NMP, and accordingly it is possible to easily obtain the desired properties. It is also easy to reduce the drying temperature during the formation of the coating film.

In one embodiment, the method of manufacturing a semiconductor device at least includes forming an insulating film (insulating layer) by applying and drying the paint (resin composition) of the above embodiment on the surface of the substrate on which the semiconductor element is mounted, and forming a resin sealing layer on the above insulating layer.

In the above manufacturing method, from the viewpoint of workability, the above resin composition preferably contains a polyamideimide resin as a resin component. The above insulating layer can be formed by applying the above resin composition to a predetermined portion and drying the coating film. The above resin composition can be applied by using various application methods. The application methods are not particularly limited, but examples thereof include spray coating methods, potting methods, dipping methods, and dispensing methods. Considering workability and the like, the potting method or dispensed coating is preferred.

In one embodiment, the thickness of the coating film obtained upon film formation using the resin composition is not particularly limited, but may be in a range from 0.5 to 10 µm. Due to the coating film having the thickness within the above range, it tends to be easy to ensure sufficient adhesion to the substrate, for example. From this viewpoint, the film thickness is preferably in a range from 1 to 10 µm and more preferably in a range from 3 to 10 µm.

The material of the substrate is not particularly limited, and can be selected from materials well known in the technical field. From the viewpoint of manufacturing the power semiconductor device, a die pad material is preferably at least one selected from the group consisting of Ni and Cu with Ag plating formed thereon. A lead material of a lead frame is preferably selected from the group consisting of Ni and Cu.

The material of the semiconductor element is not particularly limited, and may be, for example, a silicon wafer, a silicon carbide wafer, or the like.

The resin sealing layer can be constituted by a cured product of a resin, which is well known in the technical field, as a sealing material. For example, a liquid or solid epoxy resin composition can be used as the sealing material. The resin sealing layer can be formed, for example, by performing transfer molding using the sealing material.

In another embodiment, a method of manufacturing a semiconductor device includes, for example, forming a resin layer by applying and drying the resin composition of the above embodiment on a semiconductor substrate on which multiple wires of the same structure are formed, and if necessary, forming, on the resin layer, rewiring that is electrically conductive to an electrode on the semiconductor substrate. In addition to these processes, if necessary, the method may include forming a protective layer (resin layer) using the above resin composition on the rewiring or on the resin layer. Further, in addition to the above steps, the method may include forming an external electrode terminal on the above resin layer if necessary, and then preforming dicing if necessary.

In the above semiconductor device, the semiconductor element is not particularly limited, but may be, for example, a silicon wafer, a silicon carbide wafer, or the like. The application method of the above resin layer is not particularly limited, but is preferably spin coating, spray coating, or dispensed coating. The above resin layer can be dried by means of a method known in the technical field. Since the resin composition of the above embodiment is also excellent in terms of properties such as sputtering resistance, plating resistance, and alkaline resistance which are required in the step of forming the rewiring, the composition can be suitably used as a constituent material of any semiconductor device without being limited to the configuration of the semiconductor device described above.

Exemplified embodiments of the present invention will be summarized below.
[1] A resin composition including:
   at least one resin selected from the group consisting of a polyamide, a polyamideimide, a polyimide, and a polyamic acid;
   at least one solvent A having a lactone structure; and
   at least one glycol ester solvent B 1 that is compatible with the solvent A, in which
   a mass ratio of the solvent A/the solvent B 1 is in a range from 90/10 to 75/25, and
   the resin includes a resin (A) having a structural unit represented by formula (Ia) below and a structural unit represented by formula (IIa) below, or a resin (B) having a structural unit represented by formula (IIa) below and a structural unit represented by formula (IVa) below. 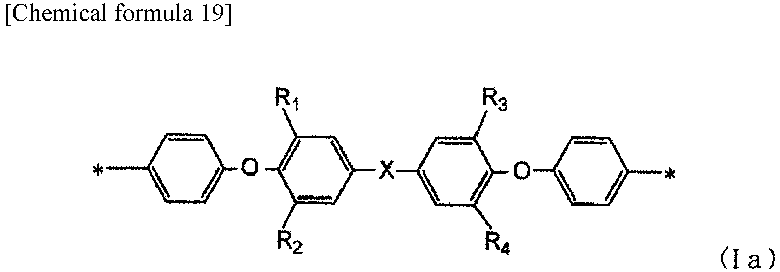 (Where R₁ to R₄ each independently represents a hydrogen atom or one or more substituents selected from the group consisting of alkyl groups of 1 to 9 carbon atoms, alkoxy groups of 1 to 9 carbon atoms, and halogen atoms;
   X is a single bond or a divalent organic group selected from the following, 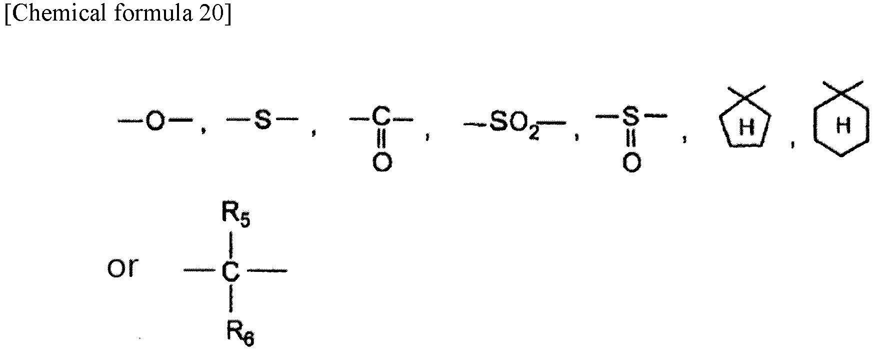
   Where R₅ and R₆ each independently represents a hydrogen atom or one or more substituents selected from the group consisting of alkyl groups of 1 to 9 carbon atoms, a trifluoromethyl group, a trichloromethyl group, and a phenyl group.) 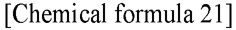 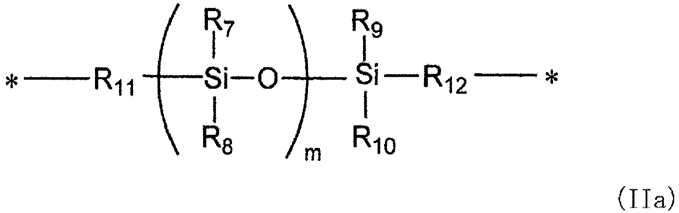 (Where R₇ to R₁₀ each independently represents a hydrogen atom or a substituent, R₁₁ and R₁₂ each independently represents a divalent hydrocarbon group, and m is an integer of 1 or more.) 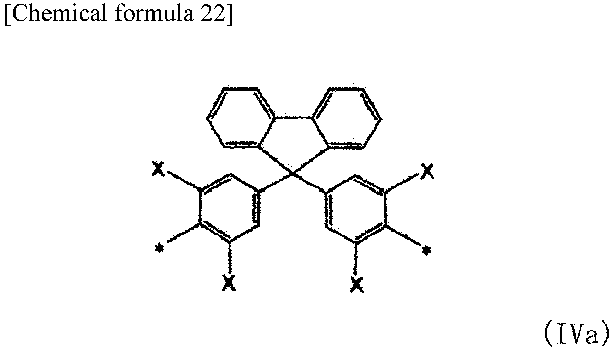 (Where each X independently represents a hydrogen atom or at least one substituent selected from the group consisting of halogen atoms, alkyl groups of 1 to 9 carbon atoms, and alkoxy groups and hydroxyalkyl groups of 1 to 9 carbon atoms.)
[2] A resin composition including:
   at least one resin selected from the group consisting of a polyamide, a polyamideimide, a polyimide, and a polyamic acid;
   at least one solvent A having a lactone structure; and
   at least one cyclic ketone solvent B2 that is compatible with the solvent A, in which
   a mass ratio of the solvent A/the solvent B2 is in a range from 70/30 to 30/70, and
   the resin includes a resin (A) having a structural unit represented by formula (Ia) below and a structural unit represented by formula (IIa) below, or a resin (B) having a structural unit represented by formula (IIa) below and a structural unit represented by formula (IVa) below. 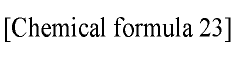 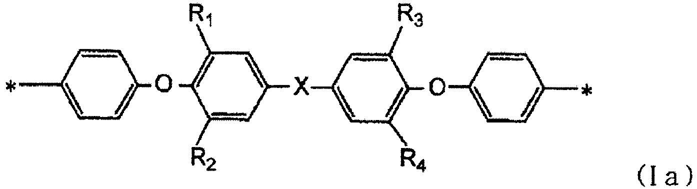 (Where R₁ to R₄ each independently represents a hydrogen atom or one or more substituents selected from the group consisting of alkyl groups of 1 to 9 carbon atoms, alkoxy groups of 1 to 9 carbon atoms, and halogen atoms;
   X is a single bond or a divalent organic group selected from the following, 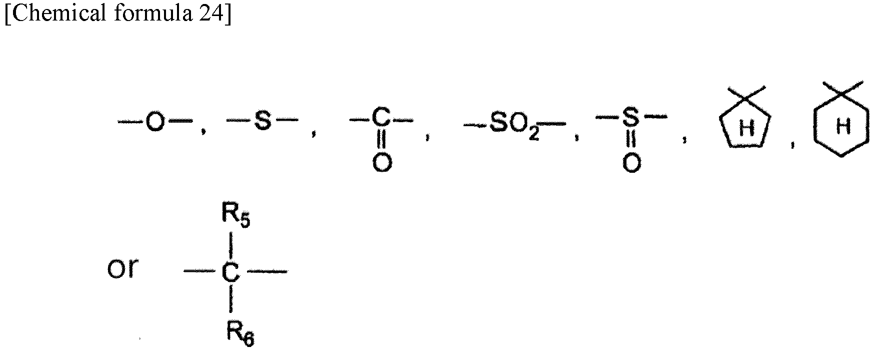
   Where R₅ and R₆ each independently represents a hydrogen atom or one or more substituents selected from the group consisting of alkyl groups of 1 to 9 carbon atoms, a trifluoromethyl group, a trichloromethyl group, and a phenyl group.) 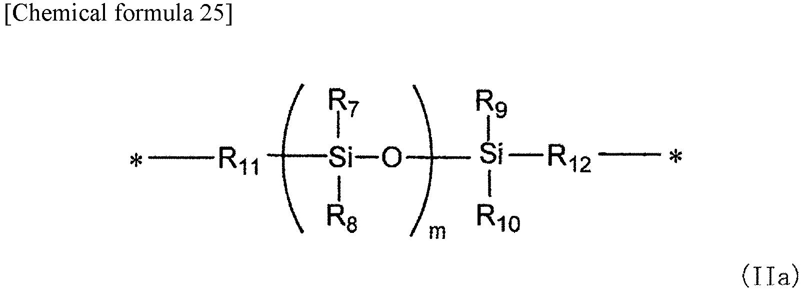 (Where R₇ to R₁₀ each independently represents a hydrogen atom or a substituent, R₁₁ and R₁₂ each independently represents a divalent hydrocarbon group, and m is an integer of 1 or more.) 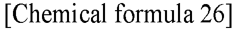 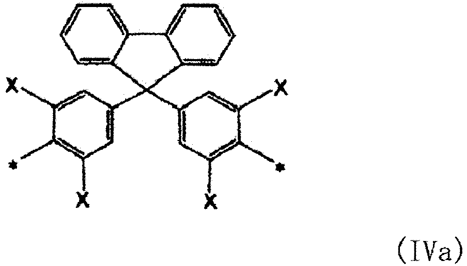 (Where each X independently represents a hydrogen atom or at least one substituent selected from the group consisting of halogen atoms, alkyl groups of 1 to 9 carbon atoms, and alkoxy groups and hydroxyalkyl groups of 1 to 9 carbon atoms.)
[3] The resin composition according to above [1] or [2], in which
   a boiling point of the solvent A is in a range from 100 to 250°C.
[4] The resin composition according to any one of [1] to [3] above, in which
   a boiling point of the solvent B1 or the solvent B2 is in a range from 100 to 250°C.
[5] The resin composition according to [1] above, in which
   the solvent A contains γ-butyrolactone and the solvent B1 contains ethylene glycol monomethyl ether acetate.
[6] The resin composition according to [2] above, in which
   the solvent A contains γ-butyrolactone and the solvent B2 contains cyclopentanone or cyclohexanone.
[7] The resin composition according to any one of [1] to [6] above, in which
   both the resin (A) and the resin (B) contain a polyamideimide further having a structural unit represented by formula (1) below. 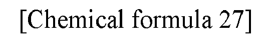 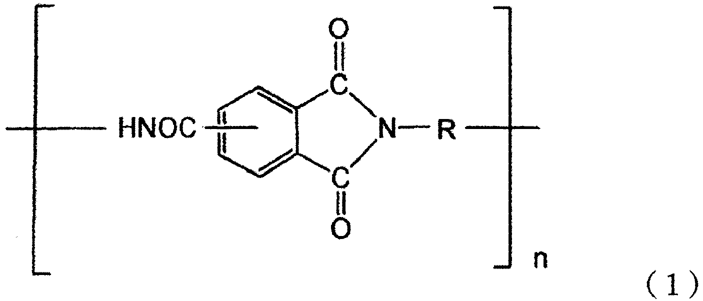 (Where R represents a residue obtained by excluding an amino group from a diamine compound or a residue obtained by excluding an isocyanate group from a diisocyanate compound, and n represents an integer of 1 or more.)
[8] The resin composition according to any one of [1] to [7] above, in which
   the resin (B) is a resin further including at least one structural unit selected from the group consisting of structural units represented by formulas (Va), (Vb), and (Vc) below. 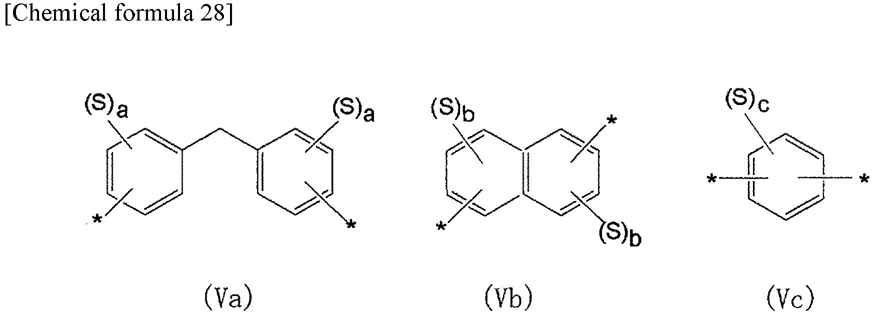 (Where each S independently represents an alkyl group of 1 to 3 carbon atoms, a represents an integer of 0 to 4, b represents an integer of 0 to 3, and c represents an integer of 0 to 4.)
[9] A semiconductor device including:
   a coating film formed using the resin composition according to any one of [1] to [8] above.
[10] A method of manufacturing a semiconductor device including:
   forming a coating film using the resin composition according to any one of [1] to [8] above.
[11] The method of manufacturing a semiconductor device according to [10] above, in which
   the coating film is formed before a sealing step.
[12] The method of manufacturing a semiconductor device according to [11] or [12] above, in which
   the coating film is a primer layer or an insulating layer.

### EXAMPLES

Various examples will be described next, but it goes without saying that the preferred embodiment of the present invention is not limited to these examples and includes many other embodiments based on the spirit of the invention.

### 1. Synthesis of polyamideimide

### (Synthesis Example 1)

In a 1-liter 4-neck flask to which a thermometer, a stirrer, a nitrogen introduction tube, and a cooling tube with an oil-water separator are attached, under a flow of nitrogen, 45.4 g of 2,2-bis[4-(4-aminophenoxy)phenyl]propane and 3.1 g of 1,3-bis(3-aminopropyl)1,1,3,3-tetramethyldisiloxane were introduced, and then further 310.1 g of N-methyl-2-pyrrolidone (hereinafter referred to as NMP) was added, and then these components were dissolved to obtain a solution.

Subsequently, 26.1 g of trimellitic anhydride chloride (hereinafter referred to as TAC) was added to the above solution while the flask was cooled to ensure that the temperature did not exceed 20°C. After stirring for 2 hours at room temperature, 15.0 g of triethylamine (hereinafter referred to as TEA) was added, and the reaction was then allowed to proceed for at least 15 hours at room temperature, thus obtaining a polyamic acid solution.

The obtained polyamic acid solution was then further heated at 180°C for 6 hours, thus obtaining a polyamideimide resin solution. The polyamideimide resin solution was poured into water, and the resulting precipitate was separated, crushed, and heat-dried to obtain a powdered polyamideimide (A).

Measurement of the weight average molecular weight (Mw) of the obtained polyamideimide (A) using gel permeation chromatography (hereinafter referred to as GPC) referenced against standard polystyrene revealed an Mw value of 98,000. The glass transition temperature (Tg) was 220°C.

### (Synthesis Example 2)

In a 1-liter 4-neck flask to which a thermometer, a stirrer, a nitrogen introduction tube, and a cooling tube with an oil-water separator were attached, under a flow of nitrogen, 15.7 g of 9,9-bis(4-aminophenyl)fluorene, 16.5 g of 4,4'-methylenebis[2,6-bis(1-methylethyl)benzenamine], and 2.5 g of 1,3-bis(3-aminopropyl)1,1,3,3-tetramethyldisiloxane were introduced, further 298 g of N-methyl-2-pyrrolidone (hereinafter referred to as NMP) was added thereto, and then these components were dissolved to obtain a solution.

Subsequently, 21.1 g of trimellitic anhydride chloride (hereinafter referred to as TAC) was added to the above solution while the flask was cooled to ensure that the temperature did not exceed 20°C. After stirring for two hours at room temperature, 12.1 g of triethylamine (hereinafter referred to as TEA) was added, and the reaction was then allowed to proceed for at least 15 hours at room temperature, thus obtaining a polyamic acid solution.

The obtained polyamic acid solution was then further heated at 180°C for 6 hours, thus obtaining a polyamideimide resin solution. The polyamideimide resin solution was poured into water, and the resulting precipitate was separated, crushed, and heat-dried to obtain a powdered polyamideimide (B).

Measurement of the weight average molecular weight (Mw) of the obtained polyamideimide (B) using gel permeation chromatography (hereinafter referred to as GPC) referenced against standard polystyrene revealed an Mw value of 67,000. The glass transition temperature (Tg) was 330°C.

The GPC measurement conditions for the polyamideimide obtained in Synthesis Examples 1 and 2 are as follows.
Feed pump: LC-20AD
UV-Vis detector: SPD-20A
Flow rate: 1 mL/min
Column temperature: 40°C
Molecular weight standards: standard polystyrenes
Eluent: NMP

Further, the measurement method for the glass transition temperature (Tg) of the polyamideimide obtained in Synthesis Examples 1 and 2 is as follows.

A varnish was prepared by dissolving the polyamideimide obtained in Synthesis Examples 1 and 2 in a mixed solvent of GBL/BuCA = 8/2. The prepared varnish was applied on a substrate using a bar coater and then heat-dried to obtain a dried film with a thickness of 10 µm. Heat-drying to form the dried film was performed under the conditions of heating the varnish at 100°C for 10 minutes and drying the varnish at 200°C for 1 hour.

Using the dried film obtained in this manner as a measurement sample, measurement was conducted in the following manner.

The measurement sample was placed in a dynamic viscoelasticity measurement device (Rheogel-E4000) manufactured by UBM Co., Ltd., and the glass transition temperature of the polyamideimide resin was measured. The measurement was performed under conditions including a chuck separation of 20 mm and a rate of temperature increase of 3°C/min, and the glass transition temperature (Tg) was obtained from the position of the tan 6 peak.

### 2. Preparation of polyamideimide resin composition

### (Example 1)

In a 0.5-liter 4-neck flask having an anchor blade of 100 mm in diameter, under a flow of nitrogen, 11.8 g of polyamideimide resin powder (A) obtained in Synthesis Example 1, 78.3 g of solvent A (GBL), 8.7 g of solvent B (BuCA), and 1.2 g of a silane coupling agent (product name: KBM-403(3-glycidoxypropylmethyldimethoxysilane) manufactured by Shin-Etsu Chemical Co., Ltd.) were added, then the mixture was stirred at 100 rpm for 12 hours, and a yellow solution was obtained.

The obtained yellow solution was filled into a filter KST-47 (manufactured by Advantec Co., Ltd.) and pressure-filtered at a pressure of 0.3 MPa to obtain resin composition (1) (solid fraction, 12.4% by mass).

### (Examples 2 to 8)

Resin compositions (2) to (8) were prepared in the same manner as in Example 1 except that the blend amounts of the resin, solvent A, solvent B, and silane coupling agent for preparing the resin composition in Example 1 were changed to those shown in Table 1. Table 1 shows various properties of the obtained resin compositions (2) to (8).

### (Comparative Example 1)

A resin composition (C1) was prepared in the same manner as in Example 1 except that the solvent A for preparing the resin composition in Example 1 was not used and the blend amounts were changed to those in Table 1. Table 1 shows various properties of the obtained resin composition (C1).

### (Comparative Example 2)

A resin composition (C2) was prepared in the same manner as in Example 1 except that the solvent B for preparing the resin composition in Example 1 was not used and the blend amounts were changed to those in Table 1. Table 1 shows various properties of the obtained resin composition (C2).

### (Comparative Example 3)

A resin composition (C2) was prepared in the same manner as in Example 1 except that BuCA was used instead of the CPN used for preparing the resin composition in Comparative Example 1. The resin was insoluble to BuCA.

### (Reference Example)

A resin composition was prepared in the same manner as in Example 1 except that NMP was used instead of the solvent A for preparing the resin composition in Example 1, and the blend amounts were changed to those in Table 1. Table 1 shows various properties of the obtained resin composition.

### 3. Various evaluation results

Various properties of the solvent A and solvent B used for preparing the resin compositions were evaluated according to the methods described below.

### <Compatibility between solvent A and solvent B>

First, 10 ml of solvent B was mixed with 10 ml of solvent A in a colorless transparent glass container. Then, the mixture was stirred (dispersed) at 25°C to obtain a solution, and the solution was placed in a stationary position for 10 minutes. Thereafter, visual observation was performed for an interface between the solutions from the side of the glass container. If an interface was observed in the solution, it was determined that the solvents were "not compatible". Meanwhile, if an interface was not observed in the solution, it was determined that the solvents were "compatible". Table 1 shows the results determined for the solvents used in each example.

### <Moisture content in solvent B>

30 g of dried solvent B was put into a cylindrical container with a radius of 2 cm, and the moisture content in the solvent B after storage for 3 hours at 30°C and 60% RH was measured. The measurement was performed at room temperature using a moisture meter CA-21 manufactured by Nittoseiko Analytech Co., Ltd. Table 1 shows the results.

### <Viscosity of resin composition>

Using a viscometer (RE type) manufactured by Toki Sangyo Co., Ltd., the measurement temperature was set at 25°C ± 0.5°C, then 1 mL to 1.5 mL of the resin composition was put into the viscometer, and the viscosity 10 minutes after the start of the measurement was measured.

Various properties of the resin compositions prepared in the examples and comparative examples were evaluated according to methods described below.

### <Evaluation of whitening (resin precipitation)>

20 mg of resin composition was applied on a glass plate. Then, the glass plate with an undried coating film was placed on a grating set in a thermostatic bath at 30°C and 50% RH, and the top thereof was covered to prevent direct exposure to airflow. The appearance of the coating film after the glass plate was placed in a stationary position for 5 minutes in this state was evaluated visually. Table 1 shows the evaluation results.

### (Evaluation criteria)

A: There was no change in appearance after 5 minutes.
B: White shadow was observed, but the coating film remained transparent.
C: White precipitation occurred and the coating film became opaque.

### <Surface roughness>

Surface roughness after a spray application step was measured for the resin compositions obtained in the examples and comparative examples. Specifically, first, the resin compositions in the examples and comparative examples were applied in evenly spaced lines over the entirety of a silicon mirror wafer using a spray coating device manufactured by SAN-EI TECH LTD.

The spray application conditions were as follows.
- Nozzle model number: SV-91
- Resin composition feed pressure: 0.1 MPa
- Atomizing pressure: 0.35 MPa
- Nozzle movement speed: 300 mm/s
- Line application interval: 10 mm
- Discharge: 1.2 g/5 s

Thereafter, the silicon mirror wafer on which the resin compositions were applied was placed on a hot plate at 80°C and dried for 30 minutes, and an average surface roughness Ra was measured using a surface texture measuring instrument manufactured by TOKYO SEIMITSU CO., LTD. The measurement conditions for surface roughness are as follows.
- Instrument: SURFCOM NEX 100
- Measurement range: 10 mm
- Measurement speed: 1.5 mm/s

From the values obtained in the above measurement, surface roughness (unevenness) was evaluated according to the following evaluation criteria. Table 1 shows the evaluation results.

### (Evaluation criteria)

Good: Ra is less than 0.5 µm.
Fault: Ra is 0.5 µm or more.

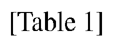

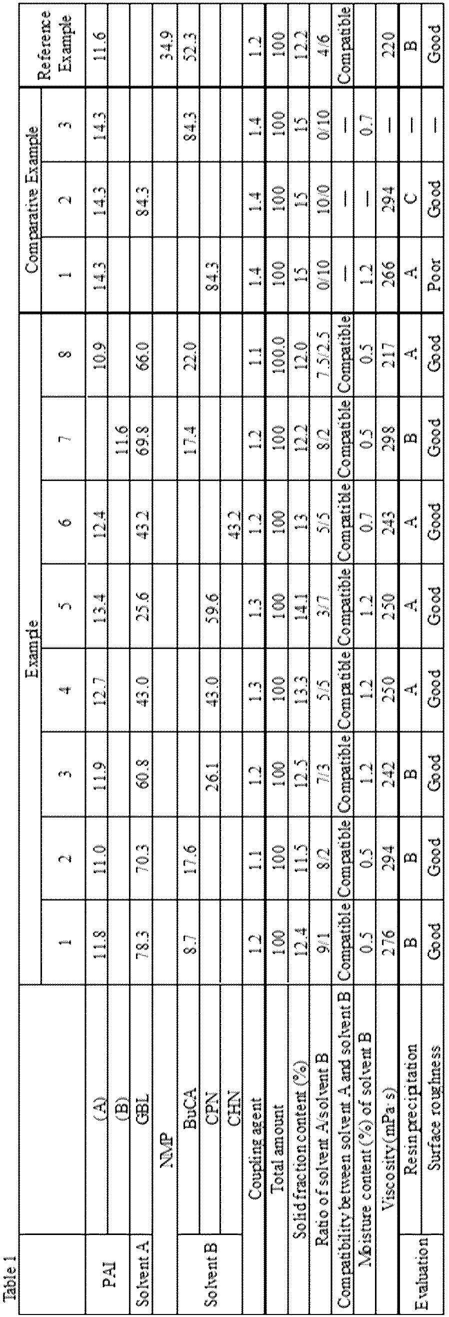

As is clear from Table 1, the polyamideimide resin compositions obtained in the embodiments of the present invention that satisfy the requirements for the combination of the specific solvent A and the specific solvent B, namely the polyamideimide resin compositions obtained in each example, can provide excellent coating film properties with suppressed resin precipitation and low surface roughness. Meanwhile, the polyamideimide resin compositions obtained in the comparative examples that do not satisfy the requirements for the combination of the specific solvent A and the specific solvent B above result in the occurrence of resin precipitation (Comparative Example 2) or resin originally not being dissolved in the solvent (Comparative Example 3). Further, even if resin precipitation is suppressed, the surface roughness was large and the coating film properties were inferior (Comparative Example 1). This is thought to be caused by the fact that while CPN is excellent in resin solubility, CPN alone is too volatile and the coating film rapidly dries after spray application.

From the above, it can be seen that according to a resin composition in which a specific solvent is used in combination as an alternative solvent for NMP, it is possible to provide a resin composition that can achieve at least the same level of properties as those achieved by using NMP as shown in the reference example.

## Claims

1. A resin composition comprising:
at least one resin selected from the group consisting of a polyamide, a polyamideimide, a polyimide, and a polyamic acid;
at least one solvent A having a lactone structure; and
at least one glycol ester solvent B 1 that is compatible with the solvent A, wherein
a mass ratio of the solvent A/the solvent B 1 is in a range from 90/10 to 75/25, and
the resin includes a resin (A) having a structural unit represented by formula (Ia) below and a structural unit represented by formula (IIa) below, or a resin (B) having a structural unit represented by formula (IIa) below and a structural unit represented by formula (IVa) below. 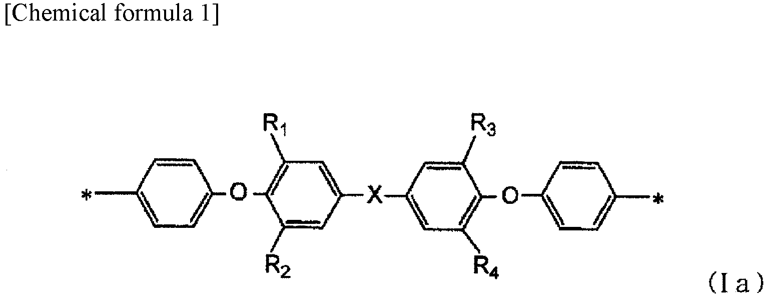 (Where R₁ to R₄ each independently represents a hydrogen atom or one or more substituents selected from the group consisting of an alkyl group of 1 to 9 carbon atoms, an alkoxy group of 1 to 9 carbon atoms, and a halogen atom,
X is a single bond or a divalent organic group selected from the following, 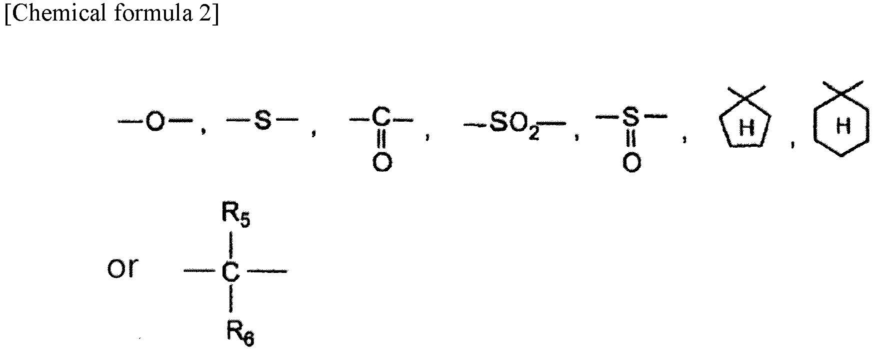
Where R₅ and R₆ each independently represents a hydrogen atom or one or more substituents selected from the group consisting of an alkyl group of 1 to 9 carbon atoms, a trifluoromethyl group, a trichloromethyl group, and a phenyl group.) 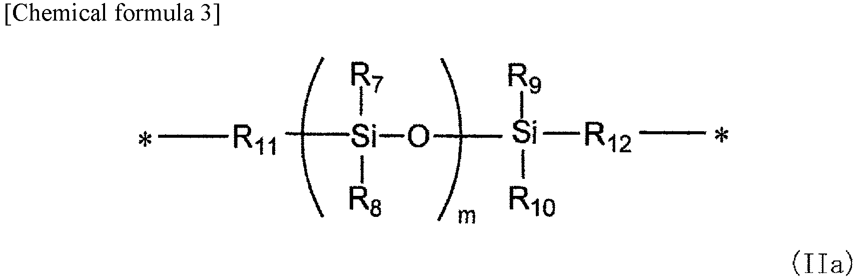 (Where R₇ to R₁₀ each independently represents a hydrogen atom or a substituent, R₁₁ and R₁₂ each independently represents a divalent hydrocarbon group, and m is an integer of 1 or more.) 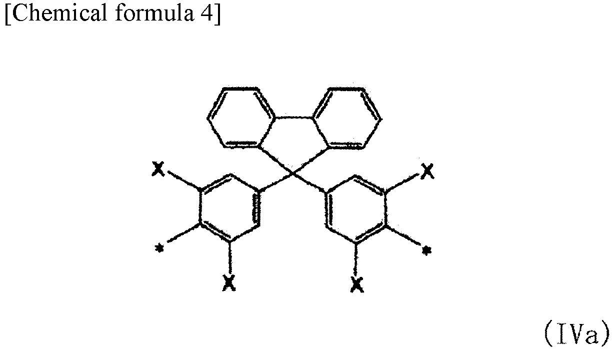 (Where each X independently represents a hydrogen atom or at least one substituent selected from the group consisting of a halogen atom, an alkyl group of 1 to 9 carbon atoms, an alkoxy group of 1 to 9 carbon atoms, and a hydroxyalkyl group of 1 to 9 carbon atoms.)

2. A resin composition comprising:
at least one resin selected from the group consisting of a polyamide, a polyamideimide, a polyimide, and a polyamic acid;
at least one solvent A having a lactone structure; and
at least one cyclic ketone solvent B2 that is compatible with the solvent A, wherein
a mass ratio of the solvent A/the solvent B2 is in a range from 70/30 to 30/70, and
the resin includes a resin (A) having a structural unit represented by formula (Ia) below and a structural unit represented by formula (IIa) below, or a resin (B) having a structural unit represented by formula (IIa) below and a structural unit represented by formula (IVa) below. 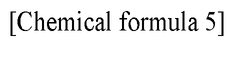 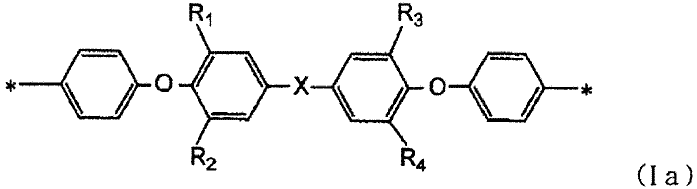 (Where R₁ to R₄ each independently represents a hydrogen atom or one or more substituents selected from the group consisting of an alkyl group of 1 to 9 carbon atoms, an alkoxy group of 1 to 9 carbon atoms, and a halogen atom,
X is a single bond or a divalent organic group selected from the following, 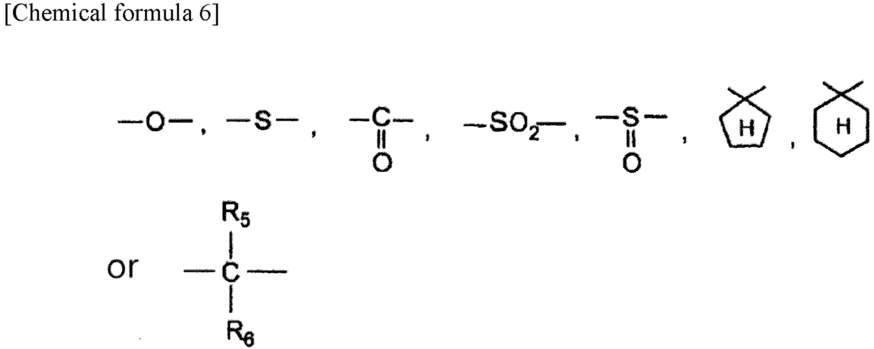
Where R₅ and R₆ each independently represents a hydrogen atom or one or more substituents selected from the group consisting of an alkyl group of 1 to 9 carbon atoms, a trifluoromethyl group, a trichloromethyl group, and a phenyl group.) 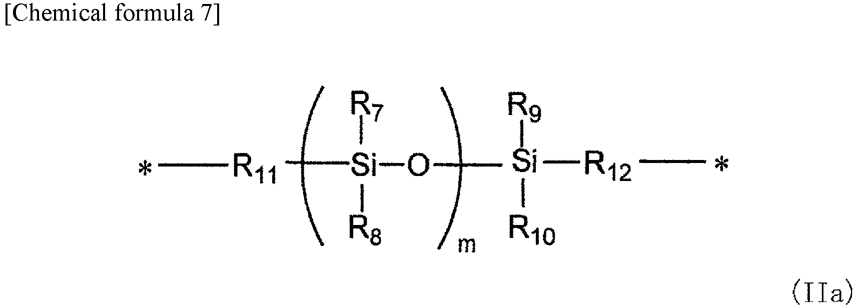 (Where R₇ to R₁₀ each independently represents a hydrogen atom or a substituent, R₁₁ and R₁₂ each independently represents a divalent hydrocarbon group, and m is an integer of 1 or more.) 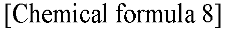 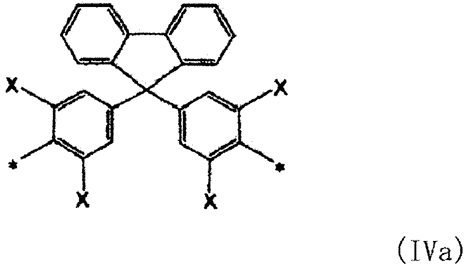 (Where each X independently represents a hydrogen atom or at least one substituent selected from the group consisting of a halogen atom, an alkyl group of 1 to 9 carbon atoms, an alkoxy group of 1 to 9 carbon atoms, and a hydroxyalkyl group of 1 to 9 carbon atoms.)

3. The resin composition according to claim 1 or 2, wherein
a boiling point of the solvent A is in a range from 100 to 250°C.

4. The resin composition according to any one of claims 1 to 3, wherein
a boiling point of the solvent B1 or the solvent B2 is in a range from 100 to 250°C.

5. The resin composition according to claim 1, wherein
the solvent A contains γ-butyrolactone and the solvent B1 contains ethylene glycol monomethyl ether acetate.

6. The resin composition according to claim 2, wherein
the solvent A contains γ-butyrolactone and the solvent B2 contains cyclopentanone or cyclohexanone.

7. The resin composition according to any one of claims 1 to 6, wherein
both the resin (A) and the resin (B) contain a polyamideimide further having a structural unit represented by formula (1) below. 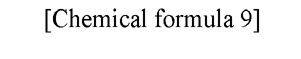 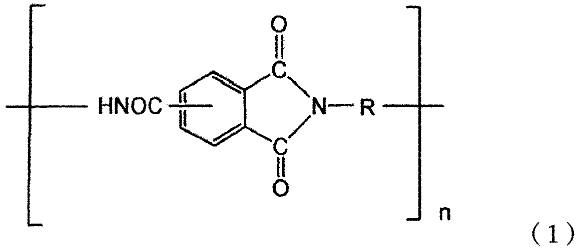 (Where R represents a residue obtained by excluding an amino group from a diamine compound or a residue obtained by excluding an isocyanate group from a diisocyanate compound, and n represents an integer of 1 or more.)

8. The resin composition according to any one of claims 1 to 7, wherein
the resin (B) is a resin further including at least one structural unit selected from the group consisting of a structural unit represented by formula (Va) below, a structural unit represented by formula (Vb) below, and a structural unit represented by formula (Vc) below. 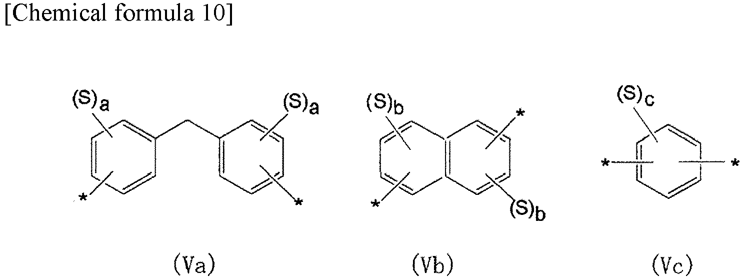 (Where each S independently represents an alkyl group of 1 to 3 carbon atoms, a represents an integer of 0 to 4, b represents an integer of 0 to 3, and c represents an integer of 0 to 4.)

9. A semiconductor device comprising:
a coating film formed using the resin composition according to any one of claims 1 to 8.

10. A method of manufacturing a semiconductor device comprising:
forming a coating film using the resin composition according to any one of claims 1 to 8.

11. The method of manufacturing a semiconductor device according to claim 10, wherein
the coating film is formed before a sealing step.

12. The method of manufacturing a semiconductor device according to claim 10 or 11, wherein
the coating film is a primer layer or an insulating layer.
